# FASCICULE DE BREVET EUROPEEN

(11) **EP 0 531 188 B1**
(45) Date de publication et mention de la délivrance du brevet: **11.12.1996**
(21) Numéro de dépôt: 92402302.1
(22) Date de dépôt: 19.08.1992
(51) Int. Cl.: H01L 39/24, H01L 39/14

(54) **Procédé de réalisation d'un conducteur composite métal/supraconducteur à haute température critique**
Verfahren zur Herstellung eines Verbundleiters aus Metall und Hoch-Temperatur-Supraleiter
Process for producing a conductor of composite metal and high temperature superconductor

(30) Priorité: 23.08.1991 FR 9110571; 17.04.1992 FR 9204813
(43) Date de publication de la demande: 10.03.1993
(73) Titulaire: ALCATEL ALSTHOM COMPAGNIE GENERALE D'ELECTRICITE, 75382 Paris Cédex 08 (FR)
(72) Inventeur: Duperray, Gérard, F-91290 Arpajon (FR); Ducatel, Françoise, F-78830 Bonnelles (FR); Legat,Denisc/o Alcatel Alsthom Recherche, 91460 Marcoussis (FR)
(74) Mandataire: Dalsace, Michel

(56) Documents cités:
- EP-A- 0 291 034
- EP-A- 0 304 403
- EP-A- 0 306 034
- EP-A- 0 405 352
- EP-A- 0 441 268
- FR-A- 1 509 601
- FR-A- 2 615 506
- GB-A- 2 092 043
- PATENT ABSTRACTS OF JAPAN vol. 015, no. 394 (E-1119)7 Octobre 1991 & JP- 58 203; & JP-A-3 159 012
- APPLIED PHYSICS LETTERS. vol. 58, no. 17, 29 Avril 1991, NEW YORK US pages 1917 - 1919 T. H. TIEFEL ET AL 'Fabrication of thin-film superconductors by bulk processing
- JOURNAL OF APPLIED PHYSICS. vol. 66, no. 6, 15 Septembre 1989, NEW YORK US pages 2762 - 2764 H. SEKINE ET AL
- PATENT ABSTRACTS OF JAPAN, vol. 015, no. 389 (M-1164) 2 Octobre 1991 & JP-A-31 58 203
- APPLIED PHYSICS LETTERS, vol. 54, no. 16, 17 Avril 1989, NEW YORK, US, pages 1582-1584, M. MIMURA et al.: "Improvement of the critical current density in the silver sheathed Bi-Pb-Sr-Ca-Cu-O superconducting tape"

## Description

La présente invention concerne un procédé de réalisation d'un conducteur composite métal/supraconducteur à haute température critique comprenant au moins une feuille composite constituée de deux couches juxtaposées, une couche à base de métal et une couche à base de matériau supraconducteur à haute température critique.

Le métal est choisi parmi les métaux ou les alliages stables en présence d'oxygène. Le supraconducteur à haute température critique est choisi de préférence parmi les phases du type :

Ln₂ Ba₄ CU₆₊ₙ O₁₄₊ₙ

(BP)₂ Sr₂ Caₙ Cu₍₁₊ₙ₎ O₆₊₂ₙ

avec:
Ln = lanthanide
BP = Bi, Bi₁₋ₓ Pbₓ, Tl
n = 0 ; 1 ; 2.

La demande de brevet européen EP-A-306 034 décrit un procédé par extrusion, préférentiellement utilisé pour réaliser des fils ou des cylindres.

On connaît trois autres méthodes en cours de développement pour réaliser de telles feuilles.

La première méthode, qui est la plus répandue et la plus avancée au niveau des performances, est décrite en particulier dans l'article de KEN-ICHI SATO et al "Proceedings of 2^{nd} International Symposium on Supraconductivity 14-17 Nov. 1989 TSUKUBA p.335 à 340".

Cette méthode consiste à introduire sous vide de la poudre supraconductrice dans un tube généralement en argent ou en cupro-aluminium, puis après fermeture, à réduire le diamètre par tréfilage et à éventuellement transformer le fil obtenu en ruban par laminage. Ces opérations mécaniques sont entrecoupées de traitements thermiques destinés à détendre le métal et à restructurer la céramique supraconductrice. Cette méthode conduit à de bons résultats mais présente l'inconvénient de confiner le matériau supraconducteur, dont les performances sont connues pour être très affectées par l'atmosphère de traitement ; il est ainsi difficile de contrôler le taux d'oxygène à l'intérieur du tube et encore plus difficile d'éliminer les très néfastes résidus de carbonates de baryum, calcium ou strontium emprisonnés dans le tube.

La seconde méthode est décrite dans les articles de K. KOSHINO "Jap. Journal of Applied physics vol. 28 n° 7, july 1989 p. 1214 à 1216" et de T.H. TIEFEL et S. SIN "Applied Physic Letters 58 (17) 29.04.91 p. 1917 à 19".

Elle consiste à déposer par sérigraphie ou pulvérisation une encre chargée en poudre supraconductice sur un substrat métallique, puis, après traitement thermique, à laminer ou presser cette structure. Cette fois, le procédé est du type "ouvert", mais les dépôts sérigraphiés sont limités à quelques dixièmes de millimètre d'épaisseur et sont très pauvres en charge céramique. Le retrait de cuisson est très élevé, d'où l'apparition de fissures difficiles à éliminer par laminage et pressage.

La troisième méthode est décrite dans la demande de brevet européen EP-A-0 291 034 ou dans l'article de K. TOGANO "Proceedings of ICMC' 90 Mai 1990 Garmisch - Partenkirchen. Editor H.C. Freyhardt Verlag".

Elle consiste à réaliser dans un premier temps une bande par coulage : une barbotine constituée de poudre de céramique supraconductrice au bismuth en suspension dans un solvant est étalée à l'aide d'un couteau sur un support, puis séchée et décollée. Dans un deuxième temps, cette bande est posée sur un feuillard d'argent, traitée thermiquement jusqu'au début de fusion pour provoquer l'adhésion, puis le tout est laminé et pressé. Ce procédé présente sur la sérigraphie l'avantage d'augmenter l'épaisseur ; par contre la nécessité de fondre, même partiellement, nuit à la pureté finale de la phase au bismuth à 110K dont la fusion conduit de manière irréversible à un mélange de phases à basses températures critiques (20K et 85K) et de Ca₂CuO₃ inerte. De plus, l'obtention par coulage d'une bande dense, non fissurée et d'épaisseur reproductible, est assez difficile, surtout dans le cas des phases supraconductrices réactives avec lesquelles bon nombre d'ajouts et de solvants (l'eau en particulier) sont incompatibles.

La présente invention a pour but de mettre en oeuvre un procédé permettant de réaliser une feuille composite de manière économique, par mise en oeuvre d'un matériel courant, offrant une grande liberté de choix des paramètres, et notamment celui de l'épaisseur de la couche supraconductrice.

La présente invention a également pour but de réaliser un conducteur composite incorporant au moins une de ces feuilles, et dont les performances soient améliorées vis-à-vis de celles des conducteurs antérieurs.

La présente invention a pour objet un procédé de réalisation d'un conducteur composite métal/supraconducteur à haute température critique comprenant au moins une feuille composite constituée de deux couches juxtaposées, une couche à base de métal et une couche à base de matériau supraconducteur à haute température critique, procédé selon lequel :
- dans une première étape on réalise ladite couche à base de matériau supraconducteur à haute température critique ou de ses précurseurs,
- dans une seconde étape on solidarise ladite couche à base de matériau supraconducteur à haute température critique par compression ou colaminage sur une bande à base d'un métal compatible avec ledit matériau supraconducteur,
- dans une troisième étape on effectue un traitement thermique pour éventuellement synthétiser le matériau supraconducteur si on est parti desdits précurseurs, et pour fritter la feuille à deux couches obtenue, procédé caractérisé par le fait que, dans ladite première étape, on agglomère, à l'aide d'une calandreuse chauffante et avec des liants organiques, de la poudre dudit matériau supraconducteur ou de ses précurseurs, de manière à obtenir une pâte qui forme une bande plastifiée souple, la quantité de ladite poudre dans ladite pâte étant comprise entre 80 % et 90 % en poids.

Les différents liants seront précisés plus loin.

Ladite bande à base de métal peut être dense et obtenue par laminage de métal massif, mais de préférence elle est obtenue comme ladite bande souple par agglomération de poudre dudit métal par des liants organiques à l'aide d'une calandreuse chauffante ; on a alors une bande métallique poreuse. Les taux de liants respectifs dans la bande plastifiée et la bande métallique sont alors choisis de façon à égaliser les retraits de ces deux bandes durant ledit traitement thermique et éviter les déformations dues à l'effet bilame.

Pour réaliser ladite bande souple plastifiée on prépare d'abord une poudre par broyage à sec :
- soit une poudre d'un matériau supraconducteur choisi parmi :

   Ln₂ Ba₄ Cu₆₊ₙ O₁₄₊ₙ

   - avec :: Ln = lanthanide
   - ou :: (BP)₂ Sr₂ Caₙ Cu₁₊ₙ O₆₊₂ₙ
   - avec :: BP = Si, Bi₁₋ₓ Pbₓ, Tl
   - et: n = O ; 1 ; 2,
- soit un mélange stoechiométrique de poudres de précurseurs correspondant au matériau supraconducteur souhaité et choisis parmi :
   Ln₂O₃, BaCO₃, SrCO₃, CaCO₃, Bi₂O₃, Bi₂(CO₃)3, PbO, Pb₃O₄, PbCO₃.

Afin de faciliter l'opération de broyage d'une telle poudre et d'augmenter son affinité vis-à-vis desdits liants organiques, on ajoute un agent surfactant choisi parmi les esters d'acides gras, tels que le trioléate de glycérol, le stéarate de glycol ou de triéthanolamine, le tripalmitate de glycérol.

Par ailleurs entre les cylindres chauffés entre 80°C et 150°C de ladite calandreuse, on malaxe lesdits liants et d'abord un polymère thermoplastique, tel que par exemple le polyéthylène, le polypropylène, l'éthylène vinyle acétate, le polystyrène.

De préférence on ajoute à ce polymère une cire microcristalline telle que l'ozokérite ou un ester d'acide gras, tel que ceux qui sont mentionnés plus haut.

Après obtention de la fusion pâteuse du polymère thermosplastique et de la cire, on incorpore par petites fractions la poudre broyée précédemment ; si cette incorporation est difficile, on peut l'aider en ajoutant de petites quantités d'agent plastifiant, par exemple un ester lourd, tel que du phtalate de dibutyle ou de dioctyle.

Le tableau suivant résume les compositions de la pâte (en masse) :
- poudre proprement dite 80 à 90%
- agent surfactant 0,2% à 1%

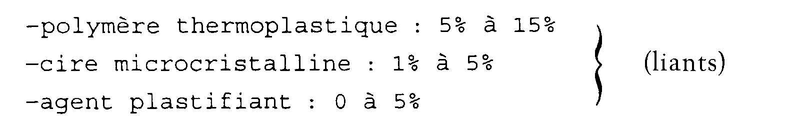

Après complète incorporation, on travaille la pâte jusqu'à parfaite homogénéité, on rapproche les cylindres de façon à calibrer la bande à l'épaisseur désirée ; on coupe alors le chauffage d'un cylindre, ce qui a pour effet de regrouper la pâte sur le cylindre chaud, on écarte les cylindres et on laisse refroidir après avoir pratiqué une saignée longitudinale dans la pâte. Cette dernière se décolle d'elle même au refroidissement ; un simple réchauffement en étuve à 100°C la ramène à la forme plane. Une telle bande plastifiée est solide et souple, très facile à calibrer et à manipuler. Sa réalisation ne nécessite que l'utilisation d'un matériel courant et bon marché.

Au cours de ladide seconde étape du procédé selon l'invention, on effectue la solidarisation de ladite bande souple plastifiée avec ladite bande métallique par une opération de compression ou une opération de colaminage.

Si l'on opère par compression, on utilise un cadre dont l'épaisseur est choisie pour que le volume qu'il définit intérieurement soit inférieur de 1% à 10% au volume de matière qu'on y place. On dispose dans ce cadre la bande souple et la bande métallique et on le place entre deux plaques de compression avec interposition de deux feuilles de papier d'aluminium.
L'ensemble est porté à une température allant de 150°C à 250°C entre les plateaux d'une presse chauffante, puis comprimé entre 5 et 20 MPascals quand on utilise une bande métallique dense et entre 1 et 5 MPascals quand on utilise une bande métallique poreuse. On refroidit et on démoule. Le papier d'aluminium pelable permet d'éviter le collage sur les plaques de compression.

Si l'on effectue la solidarisation des deux bandes par colaminage, on opère de la façon suivante.
Entre les cylindres d'une calandreuse chauffés entre 100°C et 150°C, dont l'écartement est réglé de façon à obtenir un fluage de la matière compris entre 5% et 10% et dont la vitesse de rotation est réglée pour une avance comprise entre 10 et 100 cm/minute, on introduit les deux bandes à solidariser préalablement placées entre deux papiers d'aluminium. La feuille colaminée est récupérée en sortie des cylindres après pelage du papier d'aluminium.

Dans le procédé qui vient d'être défini on a toujours solidarisé une bande plastifiée souple supraconductrice avec une bande métallique. D'autres variantes peuvent être envisagées avec une bande plastifiée souple entre deux bandes métalliques ou une bande métallique entre deux bandes plastifiées souples. Toute autre structure comprenant plusieurs structures précédentes juxtaposées peut être aussi réalisée selon l'invention.

Quelle que soit la structure "crue" ainsi obtenue, on effectue un traitement thermique dans ladite troisième étape du procédé selon l'invention.

Cette étape comporte en premier lieu une élimination des liants par montée lente (30°C/heure) de la température sous gaz neutre (N2 - Ar...) jusqu'à 500°C ou 600°C. La suite du traitement est classique et dépend du matériau supraconducteur à traiter.

Dans le cas des composés à l'yttrium (Y₂Ba₂Cu₃0₇), c'est un palier de 5 à 10 heures si le matériau a déjà été synthétisé ; si préférentiellement, il est à l'état de précurseurs, le palier est de 12 à 30 heures. Dans les deux cas, l'opération est conduite sous oxygène (entre 10 et 100%) et à des températures respectives de 880°C à 950°C. Ce palier est suivi d'une descente à 60°C/heure jusqu'à 500°C sous la même atmosphère, puis d'une descente à 20°C/heure jusqu'à 250°C préférentiellement sous oxygène pur, et enfin d'une descente à 120°C/heure.

Dans le cas des composés (BP)₂ Sr₂ Caₙ Cu₁₊ₙ 0₆₊₂ₙ, le palier est de 10 à 20 heures pour le matériau déjà synthétisé ; dans le cas préféré où des précurseurs sont employés, le palier est de 20 à 40 heures (quand n=1) ou de 50 à 200 heures (quand n=2). L'opération est conduite préférentiellement sous oxygène (entre 5 et 20%) à des températures respectives de 780°C à 870°C. Ce palier est suivi d'une descente comprise entre 60 et 240°C/heure jusqu'à 25°C, préférentiellement sous oxygène.

Le traitement thermique est complété préférentiellement par une phase d'orientation longitudinale des plans cristallographiques du matériau supraconducteur. Elle consiste de manière connue, et comme indiquée dans les références bibliographiques citées plus haut, à appliquer des contraintes mécaniques sur la feuille à deux couches. On l'écrase par laminage ou par pressage uniaxial à des pressions supérieures à 1 GPascal, puis on effectue un recuit de quelques heures. Cette opération est renouvelée jusqu'à l'obtention des performances optimales.

A partir de la feuille composite qui vient d'être définie, on peut réaliser des conducteurs souples, de faible section, pouvant être utilisés en courant alternatif dans les mêmes conditions que les conducteurs constitués des brins multifilamentaires actuellement connus.

Selon une première variante de l'invention, on effectue les opérations suivantes:
- on superpose dans un tube métallique une pluralité desdites feuilles composites, on y fait le vide et on le "queusote",
- on effectue un étirage-laminage pour réduire la section transversale dudit tube,
- on opère un traitement thermique "de détente" du conducteur obtenu.

Ledit tube métallique présente une section transversale rectangulaire ou carrée et l'on superpose lesdites feuilles composites en les empilant dans ledit tube; ladite opération d'étirage-laminage est effectuée à l'aide d'une matrice à galets écrasant ledit empilement perpendiculairement auxdites feuilles de manière à en réduire l'épaisseur; le traitement thermique de détente est effectué dès que ladite épaisseur de l'empilement est réduite d'environ 40%.

Ledit traitement thermique "de détente" a pour but de compenser l'effet néfaste d'écrouissage dû au laminage. On chauffe par exemple sous atmosphère neutre à une température comprise entre 300°C et 500°C pendant 5 à 7 heures. L'opération d'étirage-laminage et le traitement thermique "de détente" qui la suit peuvent être répétés un certain nombre de fois jusqu'à l'obtention d'un conducteur dont l'épaisseur soit comprise entre 0,1 mm et 1 mm selon les besoins.

Selon une seconde variante de l'invention on effectue les opérations suivantes:
- on enroule une feuille composite précédemment définie autour d'un mandrin métallique, la couche supraconductrice étant orientée du côté concave dudit enroulement,
- on insère l'enroulement obtenu dans un tube métallique cylindrique, on y fait le vide et on le "queusote",
- on effectue un étirage-laminage à l'aide d'un jeu de filières pour réduire la section transversale dudit tube,
- on opère un traitement thermique "de détente" du conducteur obtenu.
Le traitement thermique "de détente" est effectué dès que le diamètre dudit tube est réduit de 25% environ.

Les filières circulaires mises en oeuvre sont celles que l'on utilise habituellement pour l'étirage des câbles. Le diamètre final du conducteur est de préférence compris entre 0,5 mm et 1 mm.

De préférence, le conducteur obtenu par les modes de réalisation précédents est passé dans un laminoir dont les cylindres présentent un diamètre au moins égal à 15 cm.

En outre, le conducteur selon l'invention subit un ultime traitement thermique pour rétablir la cohésion du matériau supraconducteur qu'il contient en supprimant l'effet de "jonction faible" entre les grains.

Si ledit conducteur contient une phase supraconductrice de type Y₁Ba₂Cu₃0₇, ledit traitement thermique consiste en un passage de quelques heures à une température comprise entre 850°C et 950°C dans une atmosphère contenant 20% à 100% d'oxygène, ledit passage étant suivi d'un recuit de réoxygénation vers 450°C sous oxygène pur.

Si ledit conducteur contient une phase supraconductrice de type Bi₂Sr₂Ca₁Cu₂0₈, ledit traitement thermique consiste en un passage de quelques heures à une température comprise entre 750°C et 850°C dans une atmosphère contenant 5% à 20% d'oxygène, ledit passage étant suivi d'un recuit entre 700°C et 500°C dans une atmosphère contenant moins de 1% d'oxygène.

Si ledit conducteur obtenu contient une phase supraconductrice de type Bi₂₋ₓPbₓSr₂Ca₂Cu₃0₁₀, ledit traitement thermique consiste en un passage de quelques dizaines d'heures à une température comprise entre 800°C et 850°C dans une atmosphère contenant 3 à 20% d'oxygène, ledit passage étant suivi d'un recuit de réoxygénation vers 450°C sous oxygène pur.

Le procédé selon l'invention présente notamment les avantages suivants :
- La phase supraconductrice reste accessible durant la majeure partie de l'élaboration, d'où un meilleur échange avec l'oxygène et une grande latitude de contrôle de la pureté phasique et de l'orientation en suivi de fabrication.
- Le rapport de la section supraconductrice sur la section totale du conducteur est supérieur ou égal à 50% au lieu des 15% généralement observés pour un fil de l'art antérieur, d'où un gain potentiel de densité de courant utile.
- L'interface métal-supraconducteur, siège de l'orientation des grains, est augmentée, d'où une texturation plus efficace.

Pour un conducteur selon l'invention destiné au courant alternatif, il est préférable de diviser la surface de la couche supraconductrice de la feuille composite en chemins parallèles entre eux, de largeur inférieure ou égale à 0,1 mm, en la striant longitudinalement à l'aide d'un outil.
On peut également décomposer localement le supraconducteur par chauffage au laser.

D'autres caractéristiques et avantages de la présente invention apparaîtront au cours de la description suivante d'exemples de réalisation donnés à titre illustratif mais nullement limitatif.

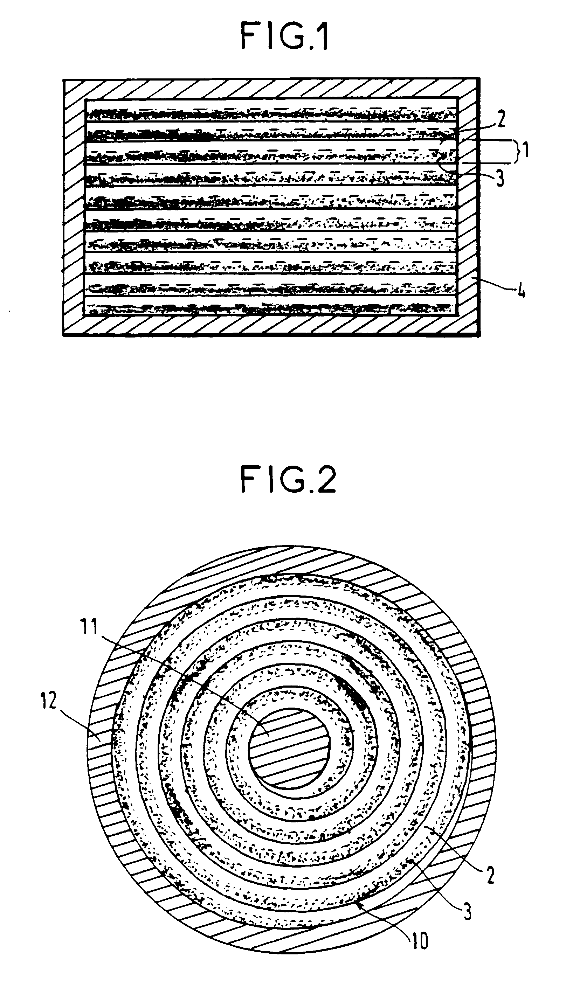

Dans le dessin annexé, les figures 1 et 2 sont des vues très schématiques en coupe d'un conducteur selon l'invention dans une phase intermédiaire de la fabrication.

### EXEMPLE 1

On broie pendant 1 heure en broyeur planétaire 11,29g de Y₂0₃ ; 39,47g de BaCO₃ et 23,86g de CuO en présence de 0,7g d'un agent surfactant tel que la "Lubromine" de la Société PROTEX. La précision de la stoechiométrie des précurseurs doit être supérieure à 1%.

Entre les cylindres d'une calandreuse chauffés à 100°C, on amène à la fusion pâteuse un mélange de 8g de polyéthylène basse densité et de 1g d'ozokérite, puis on incorpore par petites fractions la poudre broyée. Pour faciliter l'incorporation des dernières fractions, on ajoute goutte à goutte 0,5g de phtalate de dibutyle. On malaxe la pâte pendant 30 minutes, on règle l'écartement entre les cylindres à 0,45 mm et on refroidit un cylindre, ce qui a pour effet de regrouper la pâte autour du cylindre chaud qu'on refroidit à son tour. On fend longitudinalement la pâte qui, en se solidifiant, se décolle sous forme d'une bande plastifiée cintrée qu'on aplatit en la réchauffant dans une étuve à 100°C.

On empile :
- une plaque de compression,
- un papier d'aluminium,
- un cadre de 100 x 100 mm, d'épaisseur 0,5 mm, contenant une bande en argent de 0,1 mm d'épaisseur nettoyée à l'acide nitrique 50% et ladite bande plastifiée découpée,
- un second papier d'aluminium et une seconde plaque de compression.

Le tout est porté à 200°C entre les plateaux d'une presse hydraulique, puis comprimé à 20 Megapascals pendant une minute. La presse est refroidie à 80°C sous pression puis ouverte. On démoule la feuille composite argent/supraconducteur selon l'invention.

On place la feuille composite dans un four programmé de la façon suivante :
. montée à 30°C/h jusqu'à 400°C sous 0₂ 10%
. montée à 60°C/h jusqu'à 900°C sous 0₂ 10%
. 1er palier de 10 h à 900°C sous 0₂ 10%
. montée à 30°C/h jusqu'à 935°C sous 0₂ 10%
. 2ème palier de 30 h à 935°C sous 0₂ 100%
. descente à 60°C/h jusqu'à 450°C sous 0₂ 10%
. 3ème palier de 10 h à 450°C sous 0₂ 100%
. descente à 30°C/h jusqu'à 300°C sous 0₂ 100%
. descente à l'ambiante à 120°C/h sous 0₂ 100%

La feuille ainsi obtenue présente une aptitude optimale au fluage permettant de réaliser de grandes surfaces.

On porte l'épaisseur de la feuille composite de 0,4 mm à 0,1 mm par laminage et on la recuit selon un traitement thermique analogue au précédent (l'épaisseur de la couche d'argent est de 50 µm et celle de la couche supraconductrice est de 50 µm). On la lamine encore ou on la comprime jusqu'à une épaisseur de 90 µm. La feuille composite ainsi obtenue contient une phase supraconductrice particulièrement bien adaptée au fluage grâce au choix des paramètres suivants :
- stoechiométrie très précise des précurseurs,
- température élevée du second palier sous atmosphère à 10% d'oxygène correspondant à la recristallisation de la phase quadratique Y123,
- passage complet au cours du troisième palier sous oxygène pur de la phase Y123 quadratique à la phase orthorhombique.

Une telle feuille révèle une densité de courant critique de 40A/mm².

### EXEMPLE 2

On découpe la feuille composite d'épaisseur 90 µm de l'exemple 1 en languettes de 3 mm de large et de 100 mm de long à l'aide d'une guillotine. Ces languettes sont référencées 1 dans la figure 1 avec la couche supraconductrice 2 et la couche d'argent 3. Elles sont empilées pour former un faisceau que l'on introduit dans une gaine tubulaire 4 en argent, à section carrée de 3 x 3 mm (intérieur), et d'épaisseur 0,5 mm.

La gaine 4 est pompée sous vide puis "queusotée".

Elle est ensuite étirée à travers une matrice à quatre galets réglés de façon à ne pas modifier la largeur mais à réduire l'épaisseur de 15%. Le conducteur obtenu est alors détendu 10 h à 350°C sous air.

On applique ensuite six traitements mécaniques puis thermiques identiques aux précédents sauf qu'on impose à chaque fois un taux de réduction de l'épaisseur de 40% au lieu de 15%.

Le ruban obtenu, d'épaisseur 150 µm environ, est enfin traité thermiquement de la façon suivante :

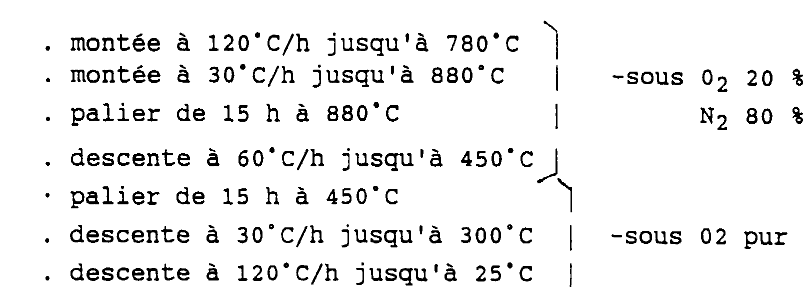

Le ruban ainsi réalisé laisse passer un courant critique de transport de 10A à 77K (pour 0 Tesla).

### EXEMPLE 3

Il est identique à l'exemple 1 sauf en ce qui concerne la bande d'argent qui, au lieu d'être découpée dans du clinquant, est une bande plastifiée obtenue en malaxant dans la calandreuse chauffante un mélange de poudre d'argent et de 10% de polyéthylène ; après refroidissement et décollage, on obtient une bande constituée respectivement en volume de 56,4% de polyéthylène et de 43,3% d'argent.

La compression est effectuée dans le même équipement que celui décrit dans l'exemple 1, mais la pression appliquée est réduite à 10 Megapascals toutes conditions égales par ailleurs.

La feuille composite obtenue est traitée ensuite dans les mêmes conditions que celle de l'exemple 1.

La mise en oeuvre dans un tube et les opérations suivantes sont analogues à celles de l'exemple 2.

### EXEMPLE 4

On broie pendant 1 heure en broyeur planétaire 18,64g de Bi₂0₃ ; 5,34g de PbCO₃ ; 14,76g de SrCO₃ : 10,00g de CaCO₃ et 11,93g de CuO en présence de 0,6g de "Lubromine".

Cette poudre est mise en forme de bande plastifiée par le procédé décrit dans l'exemple 1, puis une feuille composite est réalisée par justaposition à une bande d'argent en poudre plastifiée par 10% de polyéthylène selon le procédé décrit dans l'exemple 3.

On place la feuille dans un four programmé de la façon suivante :

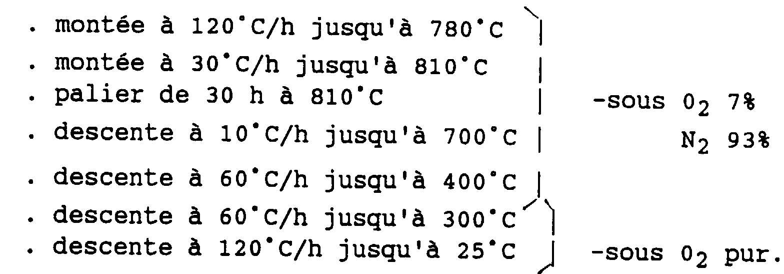

La feuille est récupérée et on porte son épaisseur de 0,4 mm à 0,1 mm par laminage; on la recuit 24 heures à 800°C sous 0₂/N₂ 10%.

Elle présente une température critique de 107K et voit sa résistance devenir nulle à 92K.

La mise en oeuvre dans un tube et les opérations suivantes sont analogues à celles de l'exemple 2.

### EXEMPLE 5

Il est identique à l'exemple 4 sauf en ce qui concerne la structure comprimée : on effectue la juxtaposition de façon à obtenir une bande de précurseurs supraconducteurs prise en "sandwich" entre deux bandes en poudre d'argent plastifiées. Le traitement thermique de synthèse est identique à celui de l'exemple 4, mais les opérations de laminage en vue d'orienter les cristallites sont grandement facilitées ; le fluage est plus régulier et la tendance au déchirement très atténuée.

### EXEMPLE 6

On prépare deux bandes plastifiées de 0,5 mm d'épaisseur respectivement en poudre de précurseurs de Y₁Ba₂Cu₃0₇ et en poudre d'argent ; toutes deux sont plastifiées par 10% de polyéthylène et 1% d'ozokérite. On règle la température des cylindres à 150°C, l'avance à 10 cm/minute et l'écartement à 0,95 mm ; on introduit entre les cylindres les deux bandes glissées entre deux feuilles d'aluminium d'épaisseur 0,05 mm ; on récupère l'ensemble collé par l'effet de la chaleur et de la pression, et on pèle les feuilles d'aluminium. Ces opérations peuvent être effectuées en continu ce qui constitue un net avantage économique. La suite du procédé est conforme à l'exemple 3.

### EXEMPLE 7

On reprend la feuille composite de 0,1 mm d'épaisseur obtenue dans l'exemple 1. Cette feuille référencée 10 dans la figure 2 est enroulée sur un mandrin 11 en argent de diamètre 5 mm, préalablement recuit, la couche supraconductrice 2 étant du côté concave.

Après enroulement de 20 spires, le cylindre bobiné obtenu est introduit dans une gaine tubulaire 12 en argent de diamètre intérieur 10 mm et extérieur 11 mm.

La gaine est pompée sous vide puis "queusotée".

Elle est ensuite étirée à travers un jeu de filières jusqu'à un taux de réduction de 25%.

Le fil obtenu est alors détendu 10 h à 350°C sous air.

On renouvelle six fois le cycle d'étirage-recuit précédent en remplaçant le dernier recuit par le traitement thermique final décrit dans l'exemple 2.

### EXEMPLE 8

Il est identique à l'exemple 7, sauf en ce qui concerne la feuille composite de départ qui est de type Ag/Bi2223, comme dans l'exemple 4 précité.

Bien entendu l'invention n'est pas limitée aux modes de réalisation qui viennent d'être décrits. On pourra, sans sortir du cadre de l'invention, remplacer tout moyen par un moyen équivalent.

## Revendications

1. Procédé de réalisation d'un conducteur composite métal/supraconducteur à haute température critique comprenant au moins une feuille composite constituée de deux couches juxtaposées, une couche à base de métal et une couche à base de matériau supraconducteur à haute température critique, procédé selon lequel :
- dans une première étape on réalise ladite couche à base de matériau supraconducteur à haute température critique pu de précurseurs,
- dans une seconde étape on solidarise ladite couche à base de matériau supraconducteur à haute température critique par compression ou colaminage sur une bande à base d'un métal compatible avec ledit matériau supraconducteur,
- dans une troisième étape on effectue un traitement thermique pour éventuellement synthétiser le matériau supraconducteur si on est parti desdits précurseurs, et pour fritter la feuille à deux couches obtenue, procédé
caractérisé par le fait que, dans ladite première étape, on agglomère, à l'aide d'une calandreuse chauffante et avec des liants organiques, de la poudre dudit matériau supraconducteur ou de ses précurseurs, de manière à obtenir une pâte qui forme une bande plastifiée souple, la quantité de ladite poudre dans ladite pâte étant comprise entre 80 % et 90 % en poids.

2. Procédé de réalisation selon la revendication 1, caractérisé par le fait que ladite bande à base d'un métal compatible avec ledit matériau supraconducteur est obtenue comme ladite bande souple, par agglomération de poudre dudit métal par des liants organiques à l'aide d'une calandreuse chauffante.

3. Procédé selon la revendication 1, caractérisé par le fait que ladite poudre dudit matériau supraconducteur a pour formule :
Ln₂ Ba₄ Cu₆₊ₙ O₁₄₊ₙ
avec : Ln = lanthanide
ou : (BP)₂ Sr₂ Caₙ Cu₁₊ₙ O₆₊₂ₙ
avec : BP = Si, Bi₁₋ₓ Pbₓ, Tl
et n = O ; 1 ; 2.

4. Procédé selon la revendication 1, caractérisé par le fait que ladite poudre est un mélange stoechiométrique de précurseurs choisis parmi :
Ln₂O₃, BaCO₃, SrCO₃, CaCO₃, Bi₂O₃, Bi₂(CO₃)₃, PbO, Pb₃O₄, PbCO₃.

5. Procédé selon l'une des revendications 3 et 4,
caractérisé par le fait que, lors de l'opération d'agglomération à l'aide de la calandreuse chauffante, ladite pâte a la composition suivante (en poids) :
- poudre proprement dite :80 à 90%
- agent surfactant : 0,2% à 1%

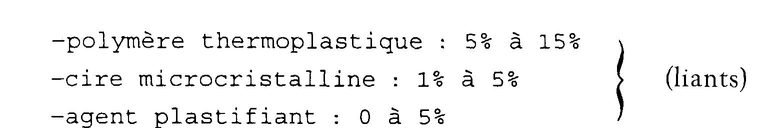

6. Procédé selon la revendication 5, caractérisé par le fait que ledit agent surfactant est choisi parmi les esters d'acides gras tels que le trioléate de glycérol, le stéarate de glycol ou de triéthanolamine, le tripalmitate de glycérol.

7. Procédé selon la revendication 5, caractérisé par le fait que ledit polymère thermoplastique est choisi parmi le polyéthylène, le polypropylène, l'éthylène vinyle acétate, le polystyrène.

8. Procédé selon la revendication 5, caractérisé par le fait que ledit agent plastifiant est un ester lourd tel que le phtalate de dibutyle ou de dioctyle.

9. Procédé selon la revendication 1, caractérisé par le fait que, dans ladite seconde étape, on comprime entre les plateaux d'une presse chauffante portée à une température comprise entre 150°C et 250°C un cadre contenant ladite bande souple et ladite bande à base de métal, de manière à les solidariser.

10. Procédé selon la revendication 9, caractérisé par le fait que l'on comprime à une valeur comprise entre 5 et 20 MPascals si la bande métallique est dense.

11. Procédé selon la revendication 9, caractérisé par le fait que l'on comprime à une valeur comprise entre 1 et 5 MPascals si la bande métallique est poreuse.

12. Procédé selon la revendication 1, caractérisé par le fait que, dans ladite seconde étape, on introduit les deux bandes à solidariser par colaminage entre les cylindres d'une calandreuse dont l'écartement est réglé de manière à obtenir un fluage compris entre 5% et 10% et dont la vitesse de rotation permet un défilement des bandes à une vitesse comprise entre 10 et 100 centimètres par minute.

13. Procédé selon l'une des revendications précédentes, caractérisé par le fait que l'on met en oeuvre une seconde bande à base de métal compatible avec ledit matériau supraconducteur de manière que ladite bande souple plastifiée soit solidarisée sur ses deux faces à une bande métallique.

14. Procédé selon l'une des revendications 1 à 12, caractérisé par le fait que l'on met en oeuvre une seconde bande plastifiée souple supraconductrice de manière que la bande de métal soit solidarisée sur ses deux faces à une bande plastifiée souple supraconductrice.

15. Procédé selon la revendication 1, caractérisé par le fait que ledit traitement thermique est complété par une opération d'orientation au cours de laquelle on effectue plusieurs fois des opérations de laminage et de recuit, de façon à allonger ladite feuille aux dépens de son épaisseur et à orienter les plans cristallins dudit matériau supraconducteur.

16. Procédé de réalisation d'un conducteur composite selon l'une des revendications précédentes, caractérisé par le fait que
- on superpose dans un tube métallique une pluralité desdites feuilles composites, on y fait le vide et on le "queusote",
- on effectue un étirage-laminage pour réduire la section transversale dudit tube,
- on opère un traitement thermique "de détente" du conducteur obtenu.

17. Procédé selon la revendication 16, caractérisé par le fait que ledit tube métallique présente une section transversale rectangulaire ou carrée et que l'on superpose lesdites feuilles composites en les empilant dans ledit tube, ladite opération d'étirage-laminage étant effectuée à l'aide d'une matrice à galets écrasant ledit empilement perpendiculairement auxdites feuilles de manière à en réduire l'épaisseur.

18. Procédé selon la revendication 17, caractérisé par le fait qu'un traitement thermique de détente est effectué dès que ladite épaisseur de l'empilement est réduite d'environ 40%.

19. Procédé selon l'une des revendications 1 à 15, caractérisé par le fait que l'on effectue les opérations suivantes:
- on enroule ladite feuille composite autour d'un mandrin métallique, la couche supraconductrice étant orientée du coté concave dudit enroulement,
- on insère l'enroulement obtenu dans un tube métallique cylindrique, on y fait le vide et on le "queusote",
- on effectue un étirage-laminage à l'aide d'un jeu de filières, pour réduire la section transversale dudit tube,
- on opère un traitement thermique "de détente" du conducteur obtenu.

20. Procédé selon la revendication 19, caractérisé par le fait qu'un traitement thermique de détente est effectué dès que le diamètre dudit tube est réduit de 25% environ.

21. Procédé selon l'une des revendications 16 à 20, caractérisé par le fait que le conducteur obtenu passe dans un laminoir dont les cylindres présentent un diamètre au moins égal à 15 cm.

22. Procédé selon l'une des revendications 16 à 21, caractérisé par le fait que ledit conducteur obtenu contenant une phase supraconductrice de type Y₁Ba₂Cu₃0₇, on lui fait subir un ultime traitement thermique consistant en un passage de quelques heures à une température comprise entre 850°C et 950°C dans une atmosphère contenant 20% à 100% d'oxygène, ledit passage étant suivi d'un recuit de réoxygénation vers 450°C sous oxygène pur.

23. Procédé selon l'une des revendications 16 à 21, caractérisé par le fait que, ledit conducteur obtenu contenant une phase supraconductrice de type Bi₂Sr₂Ca₁Cu₂0₈, on lui fait subir un ultime traitement thermique consistant en un passage de quelques heures à une température comprise entre 750°C et 850°C dans une atmosphère contenant 5% à 20% d'oxygène, ledit passage étant suivi d'un recuit entre 700°C et 500°C dans une atmosphère contenant moins de 1% d'oxygène.

24. Procédé selon l'une des revendications 16 à 21, caractérisé par le fait que ledit conducteur obtenu contenant une phase supraconductrice de type Bi_{2-X}Pb_{X}Sr₂Ca₂Cu₃0₁₀, on lui fait subir un ultime traitement thermique consistant en un passage de quelques dizaines d'heures à une température comprise entre 800°C et 850°C dans une atmosphère contenant 3 à 20% d'oxygène, ledit passage étant suivi d'un recuit de réoxygénation vers 450°C sous oxygène pur.

25. Procédé selon l'une des revendications 16 à 24, caractérisé par le fait que, préalablement à son introduction dans ledit tube métallique, on divise la couche supraconductrice de ladite feuille composite en chemins parallèles entre eux de largeur inférieure ou égale à 0,1 mm.

26. Procédé selon la revendication 25, caractérisé par le fait que l'on effectue des stries longitudinales à l'aide d'un outil.

27. Procédé selon la revendication 26, caractérisé par le fait que l'on décompose localement le supraconducteur par chauffage au laser.

## Patentansprüche

1. Verfahren zur Herstellung eines Verbundleiters aus Metall und einem Supraleiter hoher kritischer Temperatur, der mindestens eine Verbundfolie aus zwei übereinanderliegenden Schichten enthält, nämlich einer Schicht auf Metallbasis und einer Schicht auf der Basis eines supraleitenden Materials hoher kritischer Temperatur, wobei das Verfahren folgende Schritte enthält:
- einen ersten Schritt, in dem die Basisschicht aus supraleitendem Material hoher kritischer Temperatur oder auf der Basis von Vorläufern hergestellt wird,
- einen zweiten Schritt, in dem die Schicht auf der Basis des supraleitenden Materials hoher kritischer Temperatur durch Kompression oder Walzen auf ein Band auf der Basis eines Metalls fest aufgebracht wird, das mit dem supraleitenden Material kompatibel ist,
- einen dritten Schritt, in dem eine Wärmebehandlung erfolgt, um ggf. das supraleitende Material zu synthetisieren, wenn man von den Vorläufern ausgegangen ist, oder um die erhaltene Folie aus den beiden Schichten zu sintern,
dadurch gekennzeichnet, daß in dem ersten Schritt mit Hilfe eines Heißkalanders und mit organischen Bindemitteln das Pulver aus dem supraleitenden Material oder seinen Vorläufern zusammengebacken wird, so daß sich eine Paste ergibt, die ein weiches plastifiziertes Band bildet, wobei die Menge an Pulver in der Paste zwischen 80 und 90 Gew.% liegt.

2. Herstellungsverfahren nach Anspruch 1, dadurch gekennzeichnet, daß das Band auf der Basis eines Metalls, das mit dem supraleitenden Material kompatibel ist, wie das weiche Band durch Zusammenbacken eines Pulvers des Metalls mit organischen Bindemitteln in einem Heißkalander erhalten wird.

3. Verfahren nach Anspruch 1, dadurch gekennzeichnet, daß das Pulver des supraleitenden Materials die folgende Formel Ln₂Ba₄Cu₆₊ₙO₁₄₊ₙ oder (BP)₂Sr₂CaₙCu₍₁₊ₙ₎O₆₊₂ₙ hat, wobei Ln ein Lanthanid bedeutet und BP ausgewählt wird unter Bi, Bi₁₋ₓPbₓ, Tl, und wobei n den Wert 0, 1 oder 2 hat.

4. Verfahren nach Anspruch 1, dadurch gekennzeichnet, daß das Pulver eine stöchiometrische Mischung aus Vorläufern ist, die ausgewählt werden unter
Ln₂O₃, BaCO₃, SrCO₃, CaCo₃, Bi₂O₃, Bi₂(CO₃)₃, PbO, Pb₃O₄, PbCO₃.

5. Verfahren nach einem der Ansprüche 3 und 4, dadurch gekennzeichnet, daß während des Zusammenbackens mit Hilfe des Heißkalanders die Paste die folgende Zusammensetzung (in Gew.%) hat:
- eigentliches Pulver 80 bis 90%
- Benetzungsmittel 0,2 bis 1%
- thermoplastisches Polymer 5 bis 15%
- mikrokristallines Wachs 1 bis 5% Bindemittel
- Weichmacher 0 bis 5%

6. Verfahren nach Anspruch 5, dadurch gekennzeichnet, daß das Benetzungsmittel unter den Fettsäureestern wie z.B. Glyceroltrioleat, Glykol- oder Triäthanolaminstearat und Glyceroltripalmitat ausgewählt wird.

7. Verfahren nach Anspruch 5, dadurch gekennzeichnet, daß das thermoplastische Polymer unter Polyäthylen, Polypropylen, Äthylen-Vinylacetat und Polystyrol ausgewählt wird.

8. Verfahren nach Anspruch 5, dadurch gekennzeichnet, daß der Weichmacher ein schwerer Ester wie z.B. Dibutylphtalat oder Dioctylphtalat ist.

9. Verfahren nach Anspruch 1, dadurch gekennzeichnet, daß im zweiten Verfahrensschritt zwischen den Platten einer auf eine Temperatur von zwischen 150°C und 250°C geheizten Presse ein Rahmen mit dem weichen Band und dem Band auf der Basis von Metall komprimiert wird, so daß sie sich miteinander verbinden.

10. Verfahren nach Anspruch 9, dadurch gekennzeichnet, daß man die Kompression bei einem Druck von zwischen 5 und 20 MPa durchführt, wenn das Metallband ein dichtes Band ist.

11. Verfahren nach Anspruch 9, dadurch gekennzeichnet, daß die Kompression bei einem Wert von zwischen 1 und 5 MPa erfolgt, wenn das Metallband porös ist.

12. Verfahren nach Anspruch 1, dadurch gekennzeichnet, daß im zweiten Verfahrensschritt die beiden durch gemeinsames Walzen miteinander zu verbindenden Bänder zwischen die Zylinder eines Kalanders gelangen, deren Abstand so eingestellt wird, daß sich ein Kriechen zwischen 5 und 10% ergibt, und deren Drehgeschwindigkeit einen Vorschub der Bänder bei einer Geschwindigkeit zwischen 10 und 100 cm/min erlaubt.

13. Verfahren nach einem der vorhergehenden Ansprüche, dadurch gekennzeichnet, daß ein zweites Band auf der Basis eines mit dem supraleitenden Material kompatiblen Metalls verwendet wird, so daß das weiche, plastifizierte Band auf seinen beiden Seiten mit einem Metallband fest verbunden ist.

14. Verfahren nach einem der Ansprüche 1 bis 12, dadurch gekennzeichnet, daß man ein zweites plastifiziertes, supraleitendes, weiches Band so verwendet, daß das Metallband auf seinen beiden Seiten je mit einem plastifizierten, weichen, supraleitenden Band fest verbunden wird.

15. Verfahren nach Anspruch 1, dadurch gekennzeichnet, daß die Wärmebehandlung durch eine Ausrichtoperation vervollständigt wird, während der mehrmals gewalzt und wieder erwärmt wird, so daß sich die Folie verlängert zu Lasten ihrer Dicke und die kristallinen Ebenen des supraleitenden Materials ausgerichtet werden.

16. Verfahren zur Herstellung eines Verbundleiters nach einem der vorhergehenden Ansprüche, dadurch gekennzeichnet,
- daß man in einem Metallrohr mehrere Verbundfolien übereinanderlegt, dann ein Vakuum erzeugt und das Rohr abschmilzt,
- daß man ein Zieh-Walzverfahren durchführt, um den Querschnitt des Rohrs zu verringern,
- daß man eine Wärmebehandlung zur Entspannung des erhaltenen Leiters durchführt.

17. Verfahren nach Anspruch 16, dadurch gekennzeichnet, daß das Metallrohr einen Rechteck- oder Quadratquerschnitt besitzt und daß man die Verbundfolien in dem Rohr stapelt, wobei die Zieh-Walzoperation mit Hilfe einer Matrix von Rollen erfolgt, die den Stapel senkrecht zu den Folien zerdrücken, so daß deren Dicke verringert wird.

18. Verfahren nach Anspruch 17, dadurch gekennzeichnet, daß eine Wärmebehandlung zur Entspannung durchgeführt wird, sobald die Dicke des Stapels um etwa 40% verringert ist.

19. Verfahren nach einem der Ansprüche 1 bis 15, dadurch gekennzeichnet, daß die folgenden Operationen durchgeführt werden:
- man rollt die Verbundfolie um einen Metallkern, wobei die supraleitende Schicht zur konkaven Seite der Wicklung zeigt,
- man steckt die erhaltene Rolle in ein zylindrisches Metallrohr, erzeugt ein Vakuum und schmilzt das Rohr ab,
- man führt ein Zieh-Walzen mit Hilfe eines Satzes von Zieheisen durch, um den Querschnitt des Rohrs zu verringern,
- man führt eine Wärmebehandlung des erhaltenen Leiters zur Entspannung durch.

20. Verfahren nach Anspruch 19, dadurch gekennzeichnet, daß eine Wärmebehandlung zur Entspannung durchgeführt wird, sobald der Durchmesser des Rohrs um etwa 25% verringert ist.

21. Verfahren nach einem der Ansprüche 16 bis 20, dadurch gekennzeichnet, daß der erhaltene Leiter durch eine Walze geschickt wird, deren Zylinder einen Durchmesser von mindestens gleich 15 cm besitzen.

22. Verfahren nach einem der Ansprüche 16 bis 21, dadurch gekennzeichnet, daß der erhaltene Leiter, der eine supraleitende Phase des Typs Y₁Ba₂Cu₃O₇ enthält, einer abschließenden Wärmebehandlung unterworfen wird, in der er während einiger Stunden auf einer Temperatur von zwischen 850 und 950°C in einer Atmosphäre mit 20 bis 100% Sauerstoff gehalten wird, worauf eine Wärmebehandlung zur Sauerstoffanreicherung bei etwa 450°C in reinem Sauerstoff folgt.

23. Verfahren nach einem der Ansprüche 16 bis 21, dadurch gekennzeichnet, daß der erhaltene Leiter, wenn er eine supraleitende Phase des Typs Bi₂Sr₂Ca₁Cu₂O₈ enthält, einer abschließenden Wärmebehandlung unterworfen wird, bei der er während einiger Stunden einer Temperatur zwischen 750 und 850°C in einer Atmosphäre mit zwischen 5 und 20% Sauerstoff ausgesetzt wird, worauf eine Wärmebehandlung zwischen 700 und 500°C in einer Atmosphäre mit weniger als 1% Sauerstoff folgt.

24. Verfahren nach einem der Ansprüche 16 bis 21, dadurch gekennzeichnet, daß der erhaltene Leiter, wenn er eine supraleitende Phase des Typs Bi₂₋ₓPbₓSr₂Ca₂Cu₃O₁₀ enthält, einer abschließenden Wärmebehandlung unterworfen wird, bei der er während einiger zehn Stunden einer Temperatur von zwischen 800 und 850°C in einer Atmosphäre mit zwischen 3 und 20% Sauerstoff ausgesetzt wird, worauf eine Wärmebehandlung zur Sauerstoffanreicherung bei 450°C in reinem Sauerstoff folgt.

25. Verfahren nach einem der Ansprüche 16 bis 24, dadurch gekennzeichnet, daß die supraleitende Schicht der Verbundfolie vor dem Einführen in das Metallrohr in parallele Streifen einer Breite von höchsten 0,1 mm unterteilt wird.

26. Verfahren nach Anspruch 25, dadurch gekennzeichnet, daß man Längsstreifen mit Hilfe eines Werkzeugs bildet.

27. Verfahren nach Anspruch 26, dadurch gekennzeichnet, daß man den Supraleiter örtlich durch Erwärmung mit einem Laser zersetzt.

## Claims

1. Method of manufacturing a metal/superconductor composite conductor having a high critical temperature comprising at least one composite film made up of two juxtaposed layers, a metal-based layer and a layer based on a superconductor material having a high critical temperature, in which method:
- in a first stage said layer based on a superconductor material having a high critical temperature or its precursors is made,
- in a second stage said layer based on a superconductor material having a high critical temperature is bonded by pressing or co-rolling to a strip based on a metal compatible with said superconductor material,
- in a third stage heat treatment is carried out to synthesise the superconductor material if starting with precursors, and to sinter the two-layer film obtained, which method is characterised in that, in said first stage, the powder of said superconductor material or its precursors is bound using organic binders in a heated calendering machine to obtain a paste which forms a flexible plasticised strip, the quantity of said powder in said paste being between 80% and 90% by weight.

2. Method according to claim 1 characterised in that said strip based on a metal compatible with said superconductor material is obtained in the same way as said flexible strip by binding powder of said metal with organic binders using a heated calendering machine.

3. Method according to claim 1 characterised in that said powder of said superconductor material has the formula:
Ln₂ Ba₄ Cu₆₊ₙ O₁₄₊ₙ
where : Ln = lanthanide,
or : (BP)₂ Sr₂ Caₙ Cu₁₊ₙ O₆₊₂ₙ
where : BP = Bi, Bi₁₋ₓ Pbₓ, T1
and n = 0 ; 1 ; 2.

4. Method according to claim 1 characterised in that said powder is a stoichiometric mixture of precursors selected from:
Ln₂O₃, BaCO₃, SrCO₃, CaCO₃, Bi₂O₃, Bi₂(CO₃)₃, PbO, Pb₃O₄, PbCO₃.

5. Method according to claim 3 or claim 4 characterised in that, during the operation of binding using the heated calendering machine, said paste has the following composition (by weight):
- powder proper : 80 to 90%
- surfactant : 0.2 to 1%

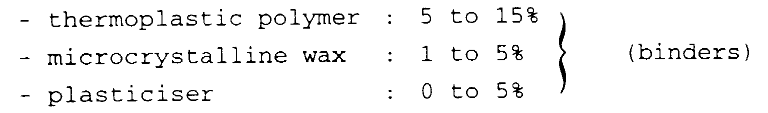

6. Method according to claim 5 characterised in that said surfactant is chosen from fatty acid esters such as glycerol trioleate, glycol or triethanolamine stearate, or glycerol tripalmitate.

7. Method according to claim 5 characterised in that said thermoplastic polymer is selected from polyethylene, polypropylene, ethylene vinyl acetate or polystyrene.

8. Method according to claim 5 characterised in that said plasticiser is a heavy ester such as dibutyl or dioctyl phthalate.

9. Method according to claim 1 characterised in that, in said second stage, a frame containing said flexible strip and said metal-based strip is compressed between the plates of a press heated to a temperature between 150°C and 250°C in order to bond them together.

10. Method according to claim 9 characterised in that the pressure applied is between 5 and 20 MPascals if the metal strip is dense.

11. Method according to claim 9 characterised in that the pressure applied is between 1 and 5 MPascals if the metal strip is porous.

12. Method according to claim 1 characterised in that, in said second stage, the two strips to be bonded together by co-rolling are inserted between the rollers of a calendering machine the distance between which is set to obtain between 5 and 10% plastic flow and whose speed of rotation enables feeding of the strips at a speed between 10 and 100 cm per minute.

13. Method according to any one of the preceding claims characterised in that a second strip based on a metal compatible with said superconductor material is used so that said plasticised flexible strip is bonded to a metal strip on each side.

14. Method according to any one of claims 1 to 12 characterised in that a second superconductor flexible plasticised strip is used so that the metal strip is bonded to a superconductor flexible plasticised strip on each side.

15. Method according to claim 1 characterised in that said heat treatment is completed by an orientation operation during which rolling and annealing are carried out several times so as to extend the length of said film at the expense of its thickness and to orient the crystal planes of said superconductor material.

16. Method of manufacturing a composite conductor according to any one of the preceding claims characterised in that:
- a plurality of said composite films are stacked in a metal tube which is evacuated and "pinched off",
- the transverse cross-section of said tube is reduced by drawing-rolling,
- heat treatment is applied to "anneal" the conductor obtained.

17. Method according to claim 16 characterised in that said metal tube has a rectangular or square transverse cross-section and said composite films are stacked in said tube, said drawing-rolling operation being carried out using a roller die to crush said stack perpendicularly to said films so as to reduce its thickness.

18. Method according to claim 17 characterised in that annealing heat treatment is carried out when the thickness of said stack is reduced by approximately 40%.

19. Method according to any one of claims 1 to 15 characterised in that the following operations are carried out:
- said composite film is wound around a metal former, the superconductor layer being on the concave side,
- the winding obtained is inserted in a cylindrical metal tube which is evacuated and "pinched off",
- the transverse cross-section of said tube is reduced by drawing-rolling using a set of dies,
- heat treatment is carried out to "anneal" the conductor obtained.

20. Method according to claim 19 characterised in that annealing heat treatment is carried out when the diameter of said tube is reduced by approximately 25%.

21. Method according to any one of claims 16 to 20 characterised in that the conductor obtained is passed through a roll mill whose rollers have a diameter of at least 15 cm.

22. Method according to any one of claims 16 to 21 characterised in that said conductor obtained contains a Y₁Ba₂Cu₃O₇ type superconductor phase and is subject to final heat treatment consisting in heating for a few hours at a temperature between 850°C and 950°C in an atmosphere containing 20% to 100% oxygen followed by re-oxygenation annealing at approximately 450°C in pure oxygen.

23. Method according to any one of claims 16 to 21 characterised in that said conductor obtained contains a Bi₂Sr₂Ca₁Cu₂O₈ type superconductor phase and is subject to final heat treatment consisting in heating for a few hours at a temperature between 750°C and 850°C in an atmosphere containing 5% to 20% oxygen followed by annealing at between 700°C and 500°C in atmosphere containing less than 1% oxygen.

24. Method according to any one of claims 16 to 21 characterised in that said conductor obtained contains a Bi₂₋ₓPbₓSr₂Ca₂Cu₃O₁₀ type superconductor phase and is subject to final heat treatment consisting in heating for a few tens of hours at a temperature between 800 and 850°C in an atmosphere containing 3% to 20% oxygen followed by re-oxygenation annealing at approximately 450°C in pure oxygen.

25. Method according to any one of claims 16 to 24 characterised in that before insertion in said metal tube the superconductor layer of said composite film is divided into parallel paths 0.1 mm wide or less.

26. Method according to claim 25 characterised in that longitudinal striations are made with a tool.

27. Method according to claim 26 characterised in that the superconductor is locally decomposed by laser heating.
